Europäisches Patentamt

European Patent Office

Office européen des brevets

(11) Numéro de publication: **0 091 333**
**B1**

(12) **FASCICULE DE BREVET EUROPEEN**

(45) Date de publication du fascicule du brevet:
30.04.86

(21) Numéro de dépôt: 83400535.7

(22) Date de dépôt: 15.03.83

(51) Int. Cl.⁴: **H 03 K 4/08, H 04 N 3/20**

(54) **Dispositif de protection de la commande de balayage horizontal d'un écran de visualisation.**

(30) Priorité: 26.03.82 FR 8205243

(43) Date de publication de la demande:
12.10.83 Bulletin 83/41

(45) Mention de la délivrance du brevet:
30.04.86 Bulletin 86/18

(84) Etats contractants désignés:
DE GB IT SE

(56) Documents cités:
DE - A - 2 057 907
FR - A - 2 132 022
FR - A - 2 317 793
GB - A - 2 007 453

FUNKSCHAU, vol. 51, no. 16, août 1979, pages 939-942, München, DE., K. REH et al.: "Transistor-Ablenk- und Stromversorgungskonzept Cessy-T"

(73) Titulaire: **THOMSON-CSF TELEPHONE, 146, Boulevard de Valmy, F-92707 Colombes (FR)**

(72) Inventeur: **Facon, Michel, THOMSON-CSF SCPI 173, Bld. Haussmann, F-75379 Paris Cedex 08 (FR)**
Inventeur: **Julien, Robert, THOMSON-CSF SCPI 173, Bld. Haussmann, F-75379 Paris Cedex 08 (FR)**

(74) Mandataire: **Weinmiller, Jürgen et al, Zeppelinstrasse 63, D-8000 München 80 (DE)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

LIBER, STOCKHOLM 1986

## Description

Dispositif de protection de la commande de balayage horizontal d'un écran de visualisation et plus particulièrement dispositif pour écran de visualisation à tube cathodique, destiné à être utilisé dans un terminal qui génère lui-même tous les signaux de synchronisation nécessaires à la visualisation d'une image sur cet écran dès la mise sous tension du terminal.

Le document "FUNKSCHAU, volume 51, numéro 16, Août 1979, pages 939-942" décrit un dispositif de protection comportant un circuit de mise en forme des signaux de synchronisation destiné à assurer la commande de balayage et un interrupteur à transistor apte à assurer ou interrompre l'alimentation du circuit de commande de balayage en fonction d'un signal qui lui est appliqué.

La commande de balayage horizontal est envoyée par l'intermédiaire du transistor qui reçoit sur sa base le signal de synchronisation. Lors de la mise sous tension de l'écran ou lors de son extinction, le signal de synchronisation n'est pas stable et de ce fait le transistor de commande de balayage nécessite une protection car il peut subir de fortes variations de courant ou de tension qui risquent de le détériorer.

Pour zéviter cet inconvénient on utilise un circuit intégré oscillant, dont la fréquence propre d'oscillation est à peu près égale à la fréquence ligne. Ce circuit permet donc d'avoir toujours un signal de synchronisation du balayage très stable si bien que le transistor n'a pas besoin d'avoir une protection particulière. Le principal inconvénient de cette méthode est le coût élevé de ce type d'oscillateur et des circuits annexes qu'il est nécessaire d'utiliser lors de la réalisation.

Pour remplacer ce circuit coûteux, l'invention propose un dispositif de protection peu encombrant et très peu onéreux, permettant de protéger le transistor qui reçoit le signal de synchronisation émis par l'unité centrale du terminal et qui commande le balayage horizontal, ce qui évite d'avoir à utiliser un oscillateur local.

Le dispositif de protection permet d'activer un circuit de balayage horizontal dès la réception d'un signal de synchronisation, il comporte un circuit de mise en forme pour recevoir le signal de synchronisation, le remettre en forme et transmettre le signal remis en forme à la commande de balayage, ainsi qu'un interrupteur apte à assurer ou interrompre l'alimentation du circuit de balayage horizontal. Selon une caractéristique de l'invention, ce dispositif de protection comporte aussi un détecteur de seuil, recevant un premier signal de niveau de tension d'alimentation envoyé par une unité centrale et délivrant un second signal fonction du niveau du premier signal, et une porte "ET" recevant respectivement à ses entrées ledit second signal et un troisième signal de commande d'alimentation de circuit de balayage et fournissant un quatrième signal à l'interrupteur pour le commander.

D'autres particularités et avantages apparaîtront clairement dans la description suivante présentée à titre d'exemple non limitatif en regard des figures annexées suivantes qui représentent:
- figure 1, un schéma général d'un dispositif de protection de commande de balayage selon l'invention,
- figure 2, un schéma détaillé d'une réalisation particulière de l'interrupteur 5 et du circuit de balayage 2,
- figure 3, un schéma d'une réalisation particulière du détecteur de seuil 3,
- figure 4, un schéma d'une réalisation particulière du circuit de mise en forme 7,
- figure 5, un diagramme des temps.

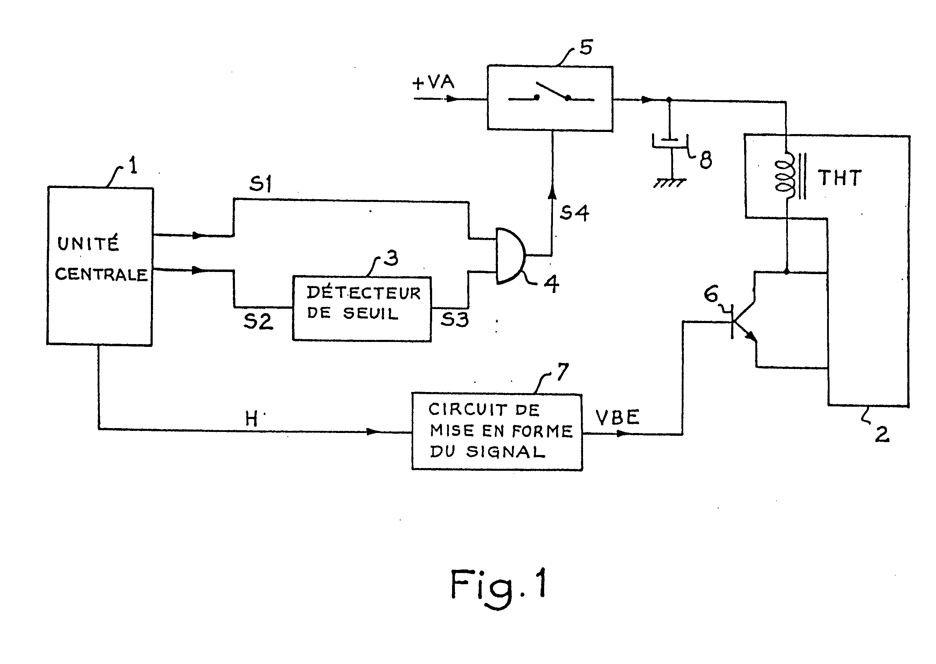

Le dispositif de protection de la commande de balayage horizontal d'un écran de visualisation est illustré schématiquement par la figure 1.

Ce dispositif reçoit un signal de synchronisation H envoyé par un organe appelé unité centrale 1 dès qu'une phase d'initialisation a été effectuée. Cette unité centrale est l'organe intelligent du terminal dans lequel est placé le dispositif de protection.

La phase d'initialisation consiste à transmettre des ordres externes (qui sont tapés sur un clavier relié au terminal par exemple) pour commander un ensemble de séquences.

Ces séquences consistent à générer le signal de synchronisation H et à générer un signal de commande d'alimentation du circuit de balayage 2.

Dès la mise sous tension du terminal et dès la réception de l'ordre externe, l'unité centrale 1 génère donc le signal de synchronisation H et un signal S1 de commande d'alimentation du circuit de balayage 2.

Un détecteur de seuil 3 reçoit un signal S2 représentant le niveau de tension d'alimentation de l'unité centrale 1. Il effectue une comparaison entre le niveau de tension donné par ce signal S2 et un seuil prédéterminé.

Si le niveau de tension détecté est égal ou supérieur au seuil prédéterminé, cela signifie que la tension d'alimentation est correcte. Alors le détecteur 3 délivre un signal S3. Si le niveau de tension détecté est inférieur au seuil prédéterminé, cela signifie que l'unité centrale 1 n'est pas correctement alimentée. Alors le détecteur 3 délivre un signal $\overline{S3}$; ce signal étant l'inverse du signal S3.

Une porte "ET" 4 reçoit les signaux S1 et S3 ou S1 et $\overline{S3}$ et délivre respectivement les signaux S4 ou $\overline{S4}$, le signal $\overline{S4}$ étant l'inverse du signal S4.

Un interrupteur 5 est commandé par le signal de sortie de la porte "ET" 4. Lorsque cet interrupteur 5 reçoit le signal S4, il se ferme, ce qui permet d'alimenter les circuits qui se trouvent en aval et qui commandent le balayage horizontal de l'écran. Lorsque l'interrupteur 5 reçoit le signal $\overline{S4}$, il s'ouvre, ce qui interdit l'alimentation de ces circuits.

A la mise sous tension du terminal, la tension S2 dépasse la valeur du seuil prédéterminé. Le signal S3 est à l'état logique "1" (par exemple). Après la phase d'initialisation, l'unité centrale a généré les signaux H et SI. Le signal SI est également à l'état logique "1" pour permettre à la porte 4 de délivrer un signal S4 commandant l'ouverture de l'interrupteur 5.

Lors de l'extinction du terminal, la tension d'alimentation S2 chute. Le détecteur de seuil 3 délivre le signal S̄3 qui correspond à l'état logique "0". La porte 4 délivre un signal S̄4 commandant l'ouverture de l'interrupteur 5.

Le circuit de balayage 2 reçoit le signal de synchronisation H par l'intermédiaire d'un circuit de commande 6 dès que le terminal a reçu l'ordre externe correspondant, mais il n'est alimenté que lorsque l'interrupteur 5 est fermé. Ce circuit de commande est constitué par un transistor NPN 6, monté en émetteur commun, qui reçoit sur sa base le signal de synchronisation H par l'intermédiaire d'un circuit de mise en forme 7.

Ce transistor 6 n'est donc alimenté que lorsque l'interrupteur 5 est fermé, c'est-à-dire lorsque la tension d'alimentation de l'unité centrale est correcte et que par conséquent le signal de synchronisation H est parfaitement stabilisé.

Lors de l'extinction du terminal, les tensions d'alimentation s'annulent, l'interrupteur 5 s'ouvre, mais le transistor 6 reste alimenté par un condensateur 8 qui s'est chargé lors du fonctionnement. Le courant de collecteur Ic généré ne dépasse pas une valeur maximale Icmax, limite du bon fonctionnement du transistor, car l'énergie mise en jeu est faible (elle est égale à $\frac{1}{2}$ C8 (VA)$^2$, C8 étant la capacité du condensateur 8).

Le signal de synchronisation géénzéré par l'unité centrale 1 est reçu par un circuit de mise en forme 7 qui permet de prendre en compte les impulsions de balayage ligne dont la durée est prédéterminée. Ce circuit 7, permet également de remettre en forme ce signal pour qu"il soit pris en compte par le transistor 6 aux instants significatifs.

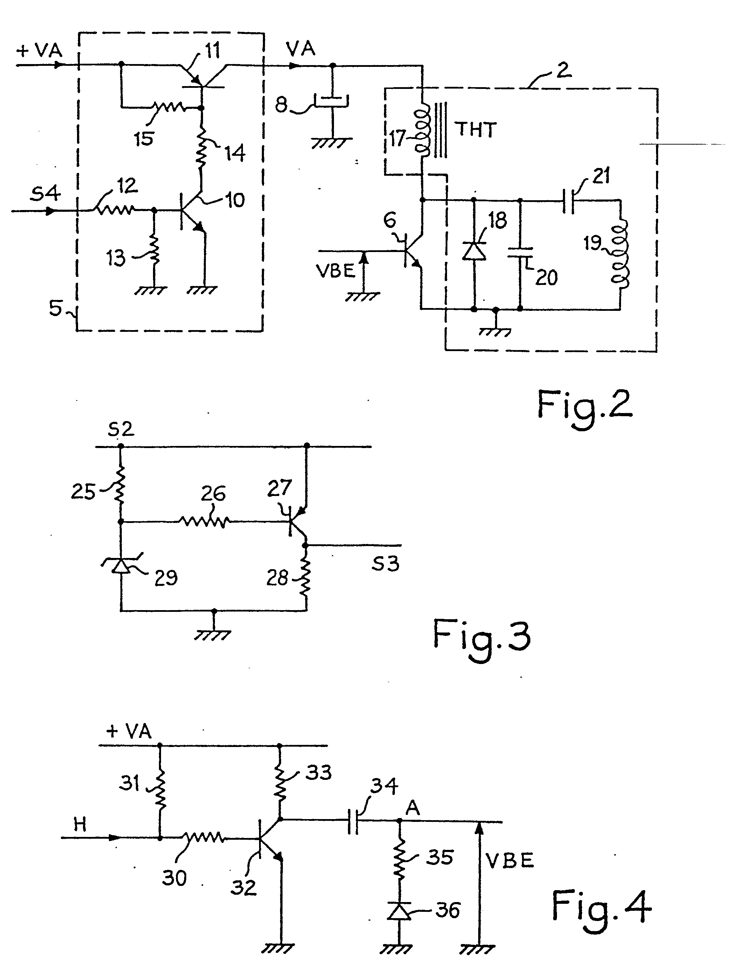

Une réalisation particulière de l'interrupteur 5 et du circuit de balayage horizontal est illustrée par la figure 2.

Cet interrupteur 5 comporte deux transistors 10 et 11.

Le transistor 10 reçoit la tension de sortie de la porte 4 (le signal S4) par l'intermédiaire d'un pont diviseur 12 et 13. Ce transistor 10 est un transistor NPN monté en émetteur commun, son collecteur est connecté à la base du transistor 11 par l'intermédiaire d'une résistance 14 et son émetteur est relié à la masse. Le transistor 11 est un transistor PNP monté en émetteur commun. L'émetteur de ce transistor reçoit la tension d'alimentation +VA, qui sert à alimenter le circuit de balayage 2 et cet émetteur est aussi relié à la base du transistor 11 par l'intermédiaire d'une résistance 15. Le collecteur du transistor est relié au condensateur chimique 8.

Lorsque la tension appliquée à la base du transistor 10 est positive, la jonction base-émetteur de ce transistor est polarisée en direct, le transistor 10 conduit.

La jonction base-émetteur du transistor 11 est alors polarisée en direct, le transistor conduit. La tension de collecteur du transistor 11 est sensiblement égale à la tension d'alimentation +VA, l'interrupteur 5 est fermé, le circuit de balayage 2 est alimenté.

Lorsque la tension appliquée à la base du transistor 10 est nulle, la jonction base-émetteur de ce transistor 10 est polarisée en inverse, le transistor est bloqué, son courant de collecteur est nul. La tension appliquée sur la base du transistor 11 est alors égale à +VA. La tension appliquée à la jonction base-émetteur est nulle. Le transistor 11 est bloqué. L'interrupteur 5 est ouvert, le circuit de balayage 2 n'est pas alimenté.

Le circuit de balayage 2 comprend un transformateur THT 17 alimenté par l'intermédiaire du condensateur 8, le collecteur du transistor de commande est chargé par ce transformateur. Une diode 18 connectée en parallèle entre le collecteur et l'émetteur du transistor 6 annule l'impulsion négative provoquée par la présence d'un circuit oscillant LC classiquement appelé déviateur horizontal.

Ce circuit LC comprend un condensateur 20 en parallèle sur la diode 18. Il comprend également un condensateur 21 en série avec une bobine 19, connectés en parallèle sur le condensateur 20. La bobine 19 délivrant un courant en dents-de-scie provoque la déviation horizontale du spot sur l'écran.

La figure 3 illustre une réalisation particulière du détecteur de seuil 3.

Ce circuit comprend un transistor PNP 27 monté en émetteur commun, l'émetteur est alimenté par le signal S2 c'est-à-dire par la tension d'alimentation de l'unité centrale 1. Le collecteur du transistor 27 délivre le signal S3 et est relié à la masse par l'intermédiaire d'une résistance 28. La base est reliée à la cathode d'une diode Zener 29 par l'intermédiaire d'une résistance 26. L'anode de la diode 29 est reliée à la masse, la cathode est reliée au signal S2 par une résistance 25.

La tension base du transistor 27 est sensiblement égale à la tension Zener, tant que la tension S2 est inférieure au seuil prédéterminé, la jonction base émetteur est polarisée en inverse, le transistor est bloqué, la sortie S3 est nulle. Lorsque la tension S2 est supérieure au seuil, la jonction base émetteur est polarisée en direct, le transistor 27 est saturé, la sortie S3 est sensiblement égale à S2, S3 est à l'état logique "1".

La figure 4 illustre une réalisation particulière du circuit de mise en forme 7.

Ce circuit comprend un transistor NPN monté en émetteur commun. La base reçoit le signal H par l'intermédiaire d'une résistance 30. Cette résistance 30 est reliée à l'alimentation +VA par une résistance 31.

Le collecteur du transistor 32 est relié à l'alimentation +VA par une résistance 33.

L'émetteur du transistor est relié à la masse. Une résistance 35 en série avec une diode 36 sont connectés entre le collecteur du transistor 32 et la masse.

La cathode de la diode 36 est reliée à la résistance 35 tandis que l'anode est reliée à la masse.

Un condensateur de liaison 34 relie le collecteur du transistor 32 à la résistance 35.

Le transistor 32 est passant, lorsque le signal H présente une impulsion de longueur déterminée et positive, la tension de sortie VBE prise entre la borne A et la masse est négative.

Lorsque le signal H est nul le transistor 32 est bloque et la tension de sortie VBE est positive.

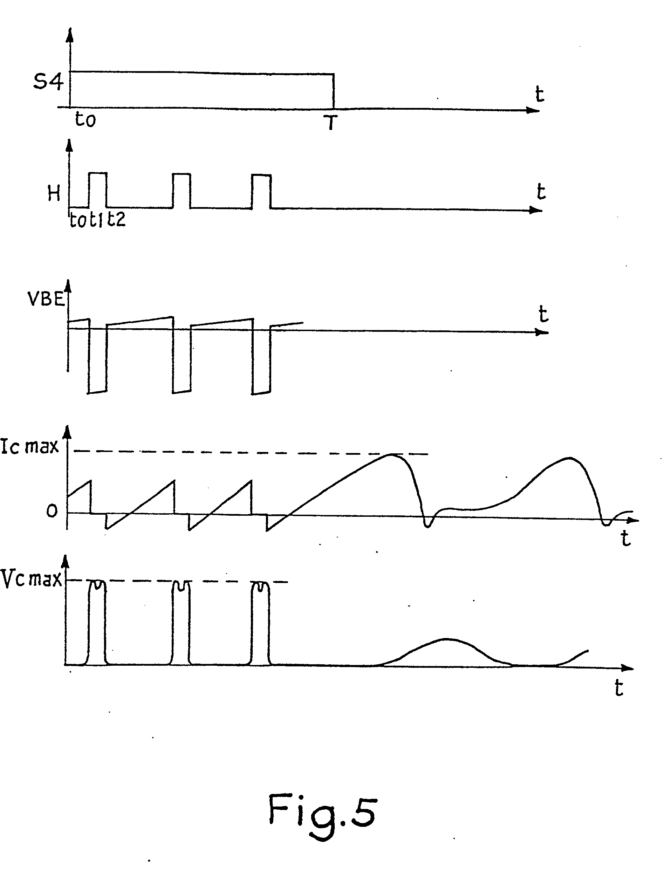

La figure 5 illustre un diagramme des temps de signaux S4, H, la tension de la jonction base-émetteur VBE du transistor de commande de balayage 6, le courant de collecteur Ic de ce transistor, et la tension de collecteur de ce transistor 6.

L'intervalle de temps T-to correspond à un bon fonctionnement de l'unité centrale 1, sa tension d'alimentation étant correcte (stable), elle génère un signal de synchronisation H périodique dont le niveau des impulsions est bien déterminé.

Le signal S4 de sortie de la porte 4 est à l'état logique "1" pendant ce même intervalle de temps et cela correspondant à la fermeture de l'interrupteur 5 et donc à l'alimentation du circuit de balayage 2.

La tension VBE est négative pendant les impulsions de l'horloge H, et positive lorsque le signal H est nul.

Le transistor 6 conduit lorsque la tension VBE est positive c'est-àdire lorsque le signal H est nul.

Pendant l'intervalle de temps T-to, le courant Ic et la tension Vc évoluent normalement.

Au-delà du temps T, on a cessé d'alimenter l'unité centrale.

Le signal S4 est à l'état logique "0" qui correspond à l'ouverture de l'interrupteur 5. Le circuit de balayage n'est plus alimenté par la tension d'alimentation +VA. Comme il s'agit dans ce cas précis d'une extinction de l'alimentation après un fonctionnement correct, le circuit de balayage 2 et le circuit de mise en forme 7 sont alimentés par le condensateur 8 pendant un temps déterminé par sa constante de temps de décharge.

On ne connait plus l'allure du signal de synchronisation H.

- Si ce signal H est nul immédiatement après la coupure de l'alimentation, ce transistor 6 est conducteur. Le courant de collecteur Ic ne dépasse pas la valeur limite Icmax pour laquelle le transistor est encore dans son aire de sécurité, car l'énergie mise en jeu est faible (elle est égale à $\frac{1}{2} C8(VA)^2$)

- Si ce signal H a une période plus longue que la période correspondant à un bon fonctionnement, la tension de collecteur Vc est limitée à une valeur limite maximale, Vcmax.

Dans notre réalisation particulière représentée sur la figure 2, les divers éléments ont pour valeurs respectives:

+VA: +30V

12:2,7KΩ
13:1 KΩ
14:4,7KΩ
15:1 KΩ
8: 10μF
19: 470μH

Le transistor 6 est un transistor NPN du type BU806 ou équivalent.

Le transistor 10 est un transistor NPN du type MPSA42 ou equivalent.

Le transistor 11 est un transistor PNP du type BD710 ou équivalent.

25: 56Ω
26: 1 KΩ
28: 680Ω

Le transistor 27 est un transistor PNP du type 2N2907 A ou équivalent.

La diode 29 est une diode Zener 3,9 V.

30: 3,9KΩ
31: 1 KΩ
33: 1 KΩ
34: 0,68μF
35: 100 Ω

Le transistor 32 est un transistor NPN du type BC372 ou équivalent. La diode 36 est du type 1N4148 ou équivalent.

**Revendications**

1/ Dispositif de protection de la commande de balayage horizontal (6) d'un écran de visualisation, cette commande de balayage permettant d'activer un circuit de balayage horizontal (2) dès la réception d'un signal de synchronisation (H), ledit dispositif comportant un circuit de mise en forme (7), pour recevoir le signal de synchronisation (H) le remettre en forme et transmettre le signal remis en forme à la commande de balayage (6), ainsi qu'un interrupteur (5), apte a assurer ou interrompre l'alimentation du circuit de balayage horizontal, et étant caractérisé en ce qu'il comporte de plus un détecteur de seuil (3) pour recevoir un premier signal (S2) de niveau de tension d'alimentation envoyé par une unité centrale (1) et délivrer un second signal (S3) fonction du niveau du premier signal, ainsi qu'une porte "ET" (4) pour recevoir respectivement à ses entrées ledit second signal (S3) et un troisième signal (S1) de commande d'alimentation de circuit de balayage et pour fournir un quatrième signal (S4) à l'interrupteur (5) pour le commander.

2/ Dispositif de protection selon la revendication 1, caractérisé en ce que l'interrupteur (5) comprend:

- un premier transistor NPN (10) monté en émetteur commun, pour recevoir sur sa base le quatrième signal (S4), l'état de ce signal permettant de bloquer le transistor ou de le rendre conducteur;

- un deuxième transistor PNP (11) monté en émetteur commun, pour recevoir sur sa base le courant de collecteur du premier transistor (10) et pour recevoir sur l'émetteur une tension d'alimentation déterminée (+VA) et délivrer ou non cette tension au circuit de balayage (2) en fonction de l'état du premier transistor (10).

3/ Dispositif de protection selon la revendication 2, caractérisé en ce que l'interrupteur (5) comprend:

- un premier pont diviseur (12, 13) relié à la base du premier transistor (10), permettant de régler le point de fonctionnement de ce premier transistor (10);

- un deuxième pont diviseur (14, 15) relié à la base du deuxième transistor (11), permettant de réégler le point de fonctionnement de ce deuxième transistor (11).

4. Dispositif de protection selon l'une quelconque des revendications 1 à 3, caractérisé en ce que le circuit de commande de balayage (6) comprend:

- un transistor NPN (6) monté en émetteur commun dont le collecteur reçoit la tension d'alimentation déterminée (+VA) par l'intermédiaire du primaire (17) d'un transformateur très haute tension, et dont la base reçoit le signal (VBE) délivré par le circuit de mise en forme (7).

5. Dispositif de protection selon l'une quelconque des revendications 1 à 4, caractérisé en ce que le détecteur de seuil (3) comprend:

- un transistor PNP (27) monté en émetteur commun qui reçoit sur son émetteur le premier signal (S2) et qui délivre sur son collecteur le deuxième signal (S3);

- une diode Zener (29) dont la tension Zener est sensiblement égale à un seuil déterminé, le transistor (27) étant conducteur lorsque sa tension base est supérieure à ce seuil déterminé et délivrant alors une tension (S3) correspondant à un état logique "I" pour la porte "ET" (4).

6. Dispositif de protection selon l'une quelconque des revendications 1 à 4, caractérisé en ce que le circuit de mise en forme (7) comprend:.

- un transistor NPN (32) monté en émetteur commun dont l'émetteur est relié à la masse et dont la base reçoit le signal de synchronisation (H), ce transistor (32) étant alimenté par la tension d'alimentation (+VA) du circuit de balayage (2) et délivrant le signal remis en forme (VBE) fonction de l'état du signal de synchronisation; ce signal étant négatif lorsque le signal de synchronisation (H) est positif et positif lorsque le signal de synchronisation est nul.

7. Dispositif de protection selon la revendication 6, caractérisé en ce que le circuit de mise en forme (7) comprend également une résistance (35) en série avec une diode (36), la cathode de cette diode étant reliée à la résistance (35) et l'anode étant reliée à la masse, la résistance étant reliée au collecteur du transistor (32) par l'intermédiaire d'un condensateur de liaison (34); cette diode (36) et cette résistance (35) permettant d'obtenir un changement d'état plus rapide du signal remis en forme (VBE) applique sur la base du transistor (6) de commande de balayage et donc un blocage plus rapide de ce transistor (6).

**Ansprüche**

1. Schutzvorrichtung der Horizontablenmkungssteuerung (6) eines Bildschirms, wobei diese Ablenkungssteuerung die Aktivierung eines Horizontalablenkkreises (2) erlaubt, sobald ein Synchronisationssignal (H) empfangen wird, und wobei die Vorrichtung einen Signalformungskreis (7), der das Synchronisationssignal (H) empfängt, es wieder in Form bringt und das resultierende Signal an die Ablenksteuerung (6) überträgt, sowie einen Schalter (5) aufweist, der die Speisung des Horizontalablenkkreises bewirken oder unterbrechen kann, dadurch gekennzeichnet, daß die Vorrichtung außerdem einen Schwellwertdetektor (3) enthält, der ein erstes Signal (S2) mit dem Pegel der Speisespannung von einer Zentraleinheit (1) zugeführt erhält und ein zweites Signal (S3) abhängig vom Pegel des ersten Signals liefert, und daß die Vorrichtung weiter ein UND-Tor (4) aufweist, das über einen seiner Eingänge das zweite Signal (S3) und über den anderen Eingang ein drittes Signal (S1), nämlich ein Ablenkkreis-Speisesteuersignal zugeführt erhält und dem Schalter (5) ein viertes Signal (S4) zu dessen Steuerung liefert.

2. Schutzvorrichtung nach Anspruch 1, dadurch gekennzeichnet, daß der Schalter (5)

- einen ersten Transistor (10) vom NPN-Typ in Emitter-Basisschaltung, dessen Basis das vierte Signal (S4) zugeführt wird, wobei mit diesem Signal der Transistor gesperrt oder leitend gesteuert werden kann,

- und einen zweiten Transistor (11) vom PNP-Typ in Emitter-Basisschaltung aufweist, dessen Basis der Kollektorstrom des ersten Transistors (10) zugeführt wird und der über den Emitter eine bestimmte Speisespannung (+VA) empfängt, wobei er diese Spannung dem Ablenkkreis (2) liefert oder nicht, je nach dem Zustand des ersten Transistors (10).

3. Schutzvorrichtung nach Anspruch 2, dadurch gekennzeichnet, dadurch gekennzeichnet, daß der Schalter (5)

- eine erste Teilerbrücke (12, 13), die an die Basis des ersten Transistors (10) angeschlossen ist und die Regelung des Betriebspunkts dieses ersten Transistors (10) erlaubt,

- und eine zweite Teilerbrücke (14, 15) aufweist, die an die Basis des zweiten Transistors (11) angeschlossen ist und die Regelung des Betriebspunkts dieses zweiten Transistors (11) erlaubt.

4. Schutzvorrichtung nach einem beliebigen der Ansprüche 1 bis 3, dadurch gekennzeichnet, daß der Ablenksteuerkreis (6) einen Transistor (6) vom NPN-Typ in Emitter-Basisschaltung aufweist, dessen Kollektor die bestimmte Speisespannung (+VA) über die Primärspule (17) eines Höchstspannungstransformators zugeführt erhält und dessen Basis das vom Signalformungskreis (7) erzeugte Signal (VBE) zugeführt erhält.

5. Schutzvorrichtung nach einem beliebigen der Ansprüche 1 bis 4, dadurch gekennzeichnet, daß der Schwellwertdetektor (3)
- einen Transistor (27) vom PNP-Typ in Emitter-Basisschaltung, dessen Emitter das erste Signal (S2) zugeführt erhält und der an seinem Kollektor das zweite Signal (S3) liefert,
- und eine Zenerdiode (29) aufweist; deren Zenerspannung im wesentlichem einem bestimmten Schwellwert gleicht, wobei der Transistor (27) leitend ist, wenn seine Basisspannung größer als dieser bestimmte Schwellwert ist, und dann eine Spannung (S3) entsprechend einem logischen Zustand EINS an das Und-Tor (4) liefert.

6. Schutzvorrichtung nach einem beliebigen der Ansprüche 1 bis 4, dadurch gekennzeichnet, daß der Signalformungskreis (7) einen Transistor (32) vom NPN-Typ in EmitterBasisschaltung enthalt, dessen Emitter an Masse liegt und dessen Basis das Synchronisationssignal (H) zugeführt erhalt, wobei dieser Transistor (32) mit der Speisespannung (+VA) des Ablenkkreises (2) gespeist wird und das wieder in Form gebrachte Signal (VBE) abhängig vom Zustand des Synchronisationssignals abgibt, wobei dieses Signal negativ ist, wenn das Synchronisationssignal (H) positiv ist, und positiv, wenn das Synchronisationssignal Null ist.

7. Schutzvorrichtung nach Anspruch 6, dadurch gekennzeichnet, daß der Signalformungskreis (7) außerdem einen Widerstand (35) in Reihe mit einer Diode (36) enthält, deren Kathode mit dem Widerstand (35) verbunden ist und deren Anode an Masse liegt, wobei der Widerstand andererseits an den Kollektor des Transistors (32) über einen Koppelkondensator (34) angeschlossen ist und die Diode (36) und der Widerstand (35) eine schnellere Zustandsänderung des in Form gebrachten Signals (VBE), das an die Basis des Ablenksteuerungstransistors (6) angelegt wird, und damit eine schnellere Sperrung dieses Transistors zu erreichen ermöglicht.

**Claims**

1. A protection device for the horizontal scan control (6) of a display screen, this scan control allowing the activation of a horizontal scan circuit (2) at the reception of a synchronisation signal (H), said device comprising a signal shaping circuit (7) which receives the synchronisation signal (H) shapes this signal and transmits it after shaping to the scan control (6), and a switch (5) capable of ensuring or breaking the supply of the horizontal scan circuit, characterized in that it further comprises a threshhold detector (3) receiving a first signal (S2) of the level of the supply voltage from a central unit (1) and delivering a second signal (S3) as a function of the level of the first signal, as well as an AND gate (4) the inputs of which receive said second signal (S3) and a third signal (S1) respectively, called supply control signal for the scan circuit, and supplying a fourth signal (S4) to the switch (5) for its control.

2. A protection device according to claim 1, characterized in that the switch (5) comprises:
- a first transistor (10) of the NPN type connected in common emitter configuration, receiving on its base the fourth signal (S4), the state of this signal making it possible to block the transistor or to make it conductive,
- a second transistor (11) of the PNP type connected in common emitter configuration, which receives at its base the collector current of the first transistor (10) and on its emitter a predetermined supply voltage (+VA) and which delivers this voltage to the scan circuit (2) only if the first transistor (10) is in a particular state.

3. A protection device according to claim 2, characterized in that the switch (5) comprises
- a first divider bridge (12, 13) connected to the base of the first transistor (10) and defining the point of operation of this first transistor (10),
- a second divider bridge (14, 15) connected to the base of the second transistor (11) and defining the point of operation of this second transistor (11).

4. A protection device according to any one of claims l to 3, characterized in that the scan control circuit (6) comprises an NPN transistor (6) connected in common emitter configuration, the collector of which receives the predetermined supply voltage (+VA) through the primary winding (17) of a very high voltage transformer, and the base of which receives the output signal (VBE) of the signal shaping circuit (7).

5. A protection device according to any one of claims 1 to 4, characterized in that the threshold detector (3) comprises:
- a PNP transistor (27) connected in common emitter configuration and receiving the first signal (S2) through its emitter and furnishing the second signal (S3) through its collector,
- a Zener diode, the Zener voltage being substantially equal to a predetermined threshold, the transistor (27) being conductor as long as its base voltage exceeds this predetermined threshold, the voltage (S3) delivered in this case corresponding to a logic state "1" for the AND gate (4).

6. A protection device according to any one of claims 1 to 4, characterized in that the pulse shaping circuit (7) comprises a transistor (32) of the NPN type, connected in common emitter configuration, the emitter of which is connected to ground and the base of which receives the synchronisation signal (H), this transistor (32) being supplied with the supply voltage (+VA) of the scan circuit (2) and delivering the shaped signal (VBE) in accordance with the state of the synchronisation signal, this signal being negative, if the synchronisation signal (H) is positive, and positive, if the synchronisation signal is zero.

7. A protection device according to claim 6, characterized in that the pulse shaping circuit (7) further comprises a resistor (35) in series with a diode (36), the cathode of this diode being connected to the resistor (35) and the anode being connected to ground, the resistance being connected to the connector of the transistor (32) through a coupling capacitor (34), this diode (36) and this resistor (35) making it possible to obtain a faster change of state of the shaped signal (VBE) applied to the base of the scan control transistor (6) and thus a faster blocking of this transistor (6).

THT

UNITÉ CENTRALE

DÉTECTEUR DE SEUIL

CIRCUIT DE MISE EN FORME DU SIGNAL

+VA

S1 S2 S3 S4

H VBE

Fig.1

Fig.2

Fig.3

Fig.4

Fig.5